(19) Europäisches Patentamt

European Patent Office

Office européen des brevets

(11) EP 1 079 236 B1

(12) EUROPÄISCHE PATENTSCHRIFT

(45) Veröffentlichungstag und Bekanntmachung des Hinweises auf die Patenterteilung:
06.09.2006 Patentblatt 2006/36

(51) Int Cl.:
*G01R 33/3875* (2006.01)

(21) Anmeldenummer: 00117689.0

(22) Anmeldetag: 17.08.2000

(54) **Aktiv abgeschirmte supraleitende Magnetanordnung mit Z2-Shim**

Actively shielded superconducting magnet assembly with Z2-shim

Assemblage d'aimants supraconducteurs comportant un "shim Z2"

(84) Benannte Vertragsstaaten:
CH DE FR GB LI

(30) Priorität: 27.08.1999 DE 19940694

(43) Veröffentlichungstag der Anmeldung:
28.02.2001 Patentblatt 2001/09

(73) Patentinhaber: Bruker BioSpin AG
8117 Fällanden (CH)

(72) Erfinder:
• Schauwecker, Robert
8032 Zürich (CH)
• Bovier, Pierre-Alain
8051 Zürich (CH)
• Eckert, Daniel M.
8600 Dübendorf (CH)

(74) Vertreter: Kohler Schmid Möbus
Patentanwälte
Ruppmannstrasse 27
70565 Stuttgart (DE)

(56) Entgegenhaltungen:
DE-C- 19 525 322          US-A- 4 180 769

**Beschreibung**

Die Erfindung betrifft eine supraleitende Magnetanordnung für magnetische Resonanz-Spektrometer, wobei die Magnetanordnung einen aktiv abgeschirmten supraleitenden Magneten zur Erzeugung eines homogenen Magnetfelds $H_0$ entlang einer z-Achse in einem um z=0 angeordneten Arbeitsvolumen mit einem radial inneren und einem radial äußeren Spulensystem umfaßt, wobei die beiden Spulensysteme näherungsweise den gleichen Strom tragen und näherungsweise entgegengesetzt gleich große Dipolmomente aufweisen, und wobei eine Shimanordnung vorgesehen ist, welche ein supraleitendes Shimspulensystem zur Korrektur von Magnetfeld-Inhomogenitäten im Arbeitsvolumen umfaßt, deren z-Komponente proportional zu $z^2$ variiert.

Eine derartige aktiv abgeschirmte supraleitende Magnetanordnung mit $Z^2$-Shimeinrichtung umfaßt beispielsweise das von der Firma Bruker Magnetics vertriebene NMR Magnet System 500 SB UltraShield™ gemäß Firmenprospekt vom 15.05.1999.

Eine aktiv abgeschirmte supraleitende Magnetanordnung ohne $Z^2$-Shim ist beispielsweise bekannt aus der EP 0 144 171 A1.

Um in Verfahren der magnetischen Resonanzspektroskopie eine gute Auflösung der Resonanzlinien im Spektrum zu erreichen, muß das Magnetfeld im Probenvolumen eine gute Homogenität aufweisen. Mit der geometrischen Anordnung der felderzeugenden Magnetspulen kann die Grundhomogenität des supraleitenden Magneten optimiert werden. Bei anspruchsvollen Anwendungen wie hochauflösender Kernspinresonanzspektroskopie ist die Grundhomogenität des Magneten meistens ungenügend, weil beispielsweise Abweichungen vom Design aufgrund von Produktionsungenauigkeiten auftreten. Um Restinhomogenitäten des Magneten zu kompensieren, wird das Magnetsystem mit autonomen supraleitenden Spulen ausgerüstet, welche Feldinhomogenitäten mit einer bestimmten geometrischen Symmetrie im Probenvolumen kompensieren können, sogenannten Shims.

Ein Beispiel für einen solchen Shim ist der $Z^2$-Shim, welcher ein Feld erzeugt, dessen Stärke entlang der Magnetachse z proportional zu $Z^2$ variiert. Ein Problem bei bekannten $Z^2$-Shimeinrichtungen nach dem Stand der Technik liegt darin, daß bei großen Magneten der Shim innerhalb der Magnetspulen gewickelt werden muß, da er außen zu schwach wäre. So geht Platz für Magnetwicklungen verloren, was den Magneten verteuert und das Streufeld vergrößert. Dies hat bei Magnetsystemen mit aktiver Streufeldkompensation zur Folge, daß die Streufeldabschirmung verstärkt werden muß.

Eine Optimierung des $Z^2$-Shims kann erreicht werden, indem der Platzbedarf der $Z^2$-Shim-Spulen, welche radial im Bereich des Spulenpaketes des Magneten liegen, reduziert wird. Ohne die Shimeffizienz zu schwächen, ist dies nur möglich, indem die Shimspulen auf mehrere Radien verteilt werden. Dabei ergeben sich neue Probleme insbesondere im Zusammenhang mit der Störung des Shims durch fluktuierende externe Magnetfelder.

Aufgabe der vorliegenden Erfindung ist es demgegenüber, eine Magnetanordnung der eingangs beschriebenen Art mit möglichst einfachen Mitteln so zu optimieren, daß die oben geschilderten Probleme nicht auftreten.

Erfindungsgemäß wird diese Aufgabe dadurch gelöst, daß das Shimspulensystem einen radial inneren Shimspulensatz umfaßt, der von der Magnetanordnung induktiv weitgehend entkoppelt ist und im Arbeitsvolumen überwiegend ein Magnetfeld erzeugt, dessen z-Komponente wie $\Delta H_0 + c_2 \cdot z^2$ mit $c_2$ = const. variiert, sowie einen radial äußeren Shimspulensatz, der ebenfalls von der Magnetanordnung induktiv weitgehend entkoppelt ist und im Arbeitsvolumen überwiegend ein homogenes Magnetfeld $-\Delta H_0$ erzeugt. Als willkommener Nebeneffekt wird dabei auch die Störempfindlichkeit des Magneten selbst reduziert.

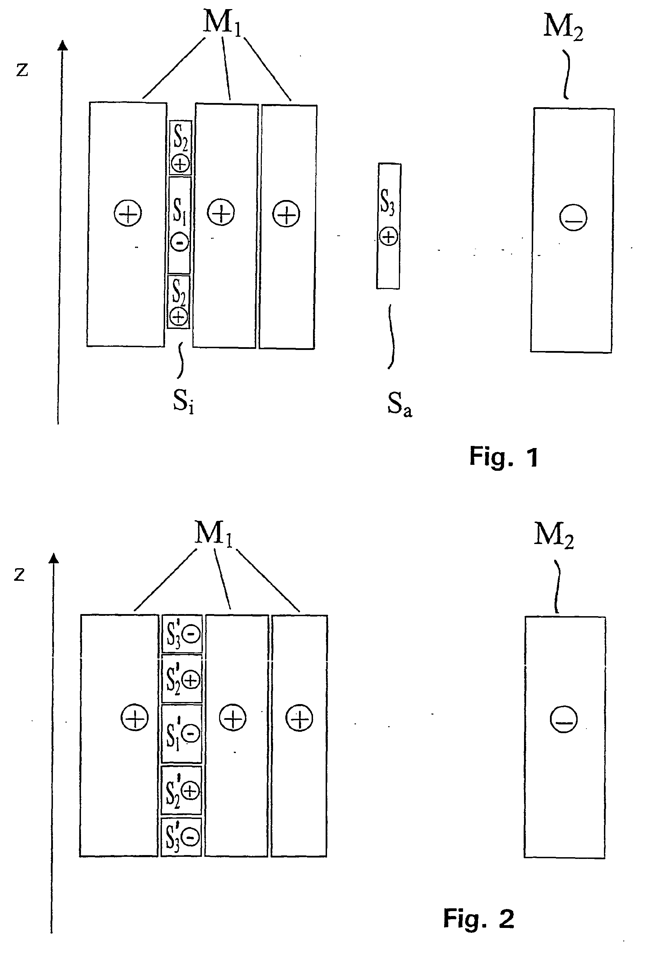

Ein konventioneller $Z^2$-Shim nach dem Stand der Technik ist in Fig. 2 schematisch dargestellt. Mit einem Spulenpaar $S_2'$ wird der $\Delta H_0$-Beitrag der Spule $S_1'$, welche den Hauptbeitrag zur Shimstärke $c_2$ liefert, kompensiert ($\Delta H_0$: homogener Feldanteil der Spule pro Ampere = pro Ampere erzeugter Feldgradient $H_0$ nullter Ordnung). Bei vollständiger $\Delta H_0$-Kompensation wird das Spulenpaar $S_2'$ normalerweise stärker mit dem Magneten koppeln als $S_1'$. Diese Kopplung wird durch ein Spulenpaar $S_3'$ aufgehoben, welches die Shimeffizienz $c_2$ stark vermindert.

Bei der vorliegenden Erfindung hingegen wird der Shim aufgeteilt in einen vom Magneten entkoppelten Shimspulensatz $S_i$ mit Teilspulen $S_1$ und $S_2$ zur Erzeugung des Gradientenfeldes $c_2 * z^2 + \Delta H_0$ und in einen ebenfalls vom Magneten entkoppelten Shimspulensatz $S_a$ mit der Teilspule $S_3$, welcher die Verunreinigung $\Delta H_0$ aufhebt. Weil die $H_2$-Effizienz einer Spule mit wachsendem Spulenradius R bei gleichbleibender Länge L stärker abnimmt als ihre $H_0$-Effizienz, muß der gradientenerzeugende Shimspulensatz $S_i$ radial weiter innen liegen als der Shimspulensatz $S_a$ zur Unterdrückung von $\Delta H_0$.

Der Vorteil dieser neuen Shimanordnung besteht darin, daß mit der Unterdrückung von $\Delta H_0$ durch einen radial außenliegenden Shimspulensatz die Shimstärke $c_2$ des radial innenliegenden Shimspulensatzes nur wenig abgeschwächt wird. Dadurch werden im radial innenliegenden Shimspulensatz weniger Windungen benötigt und der Magnet kann kompakter gebaut werden, falls der radial innenliegende Shimspulensatz sich an einem Ort befindet, wo sonst Magnetwicklungen untergebracht würden.

Der Vorteil der separaten Entkopplung des inneren und äußeren Shimspulensatzes vom Magneten besteht darin, daß auf diese Weise eine Ausführungsform möglich wird, bei der jeder der beiden Shimspulensätze für sich supraleitend kurzgeschlossen ist, ohne daß sich die einzelnen Shimspulensätze z.B. durch eine Magnetdrift, einen Quench oder beim spontanen Öffnen des Hauptschalters des Magneten aufladen können. Außerdem ist so auch der Gesamtshim vom Magneten entkoppelt, was den Vorteil der Reduktion von induzierten Strömen im Magneten beim Laden des Shims mit sich bringt.

Bei einer bevorzugten Ausführungsform der erfindungsgemäßen Magnetanordnung kann sowohl der radial innere Shimspulensatz als auch der radial äußere Shimspulensatz jeweils für sich supraleitend kurzgeschlossen werden. Daß innerer und äußerer Shimspulensatz separat kurzgeschlossen werden können, hat unter anderem Vorteile für die Produktion der Magnetanordnung, weil die Überbrückung der Radiendifferenz zwischen dem radial inneren und äußeren Shimspulensatz nicht notwendigerweise supraleitend sein muß. Zusätzlich ergibt sich die Möglichkeit, die beiden Shimanteile mit unterschiedlichen Strömen zu betreiben.

Ein entscheidender Vorteil des separaten Kurzschlusses von radial innerem und äußerem Shimspulensatz zeigt sich beim Auftreten von externen Feldfluktuationen. Damit keine Feldinhomogenitäten von der Form $\Delta I_2 * c_2 * z^2$ entstehen, reicht es nun aus, allein den inneren Shimspulensatz für die Störung durchsichtig zu machen (d.h. so auszulegen, daß eine externe Störung keinen Strom $\Delta I_2$ induziert), weil der äußere Shimspulensatz ja im wesentlichen ein homogenes Feld erzeugt, wenn die externe Störung in ihm einen Strom induziert. Unter Umständen kann der äußere Shimspulensatz zusätzlich so ausgelegt werden, daß seine Reaktion auf die externe Feldfluktuation dazu genutzt werden kann, den homogenen Anteil der Feldstörung im Arbeitsvolumen zu dämpfen.

Bei einer besonders bevorzugten Ausführungsform der erfindungsgemäßen Magnetanordnung ist die Magnetanordnung Teil einer Apparatur zur hochauflösenden Magnetresonanz-Spektroskopie. Die Vorteile der vorliegenden Erfindung zahlen sich besonders in Systemen wie hochauflösenden Magnetresonanz-Spektrometern aus, da diese Magnetsysteme wegen der hohen Homogenitätsanforderungen ohnehin schon voluminöser sind als andere und daher ein Gewinn an Kompaktheit des $Z^2$-Shims besonders ins Gewicht fällt.

Vorteilhaft ist eine Weiterbildung dieser Ausführungsform, bei der die Magnetresonanz-Apparatur eine Einrichtung zum Feldlock des im Arbeitsvolumen erzeugten Magnetfelds aufweist, wobei der radial innere und der radial äußere Shimspulensatz weitgehend von den Spulen der Einrichtung zum Feldlock entkoppelt sind. Ein aktiver Feldlock mit einer Spule zur Kompensation von zeitlichen Feldfluktuationen im Probenvolumen gehört zur Standardausrüstung hochauflösender Magnetresonanz-Systeme. Die Entkopplung der Feldlock-Spule vom radial inneren und äußeren Shimspulensatz bewirkt, daß beim Betätigen der Lockspule im Shim kein Strom induziert werden kann. So bleibt einerseits die Feldhomogenität erhalten und andererseits wird die Wirkung der Feldlockspule nicht beeinträchtigt.

Bevorzugt ist auch eine Weiterbildung, bei der die Magnetresonanz-Apparatur Sweep-Spulen aufweist, wobei der radial innere Shimspulensatz und der radial äußere Shimspulensatz weitgehend von den Sweep-Spulen entkoppelt sind. Die Entkopplung allfällig vorhandener Sweep-Spulen vom radial inneren und äußeren Shimspulensatz bewirkt, daß beim Betätigen der Sweep-Spulen im Shim kein Strom induziert werden kann. So bleibt einerseits die Feldhomogenität während dem Feld-Sweep erhalten und andererseits wird die Wirkung der Sweep-Spulen nicht beeinträchtigt.

Bei einer vorteilhaften Ausführungsform ist der radial innere und/oder der radial äußere Shimspulensatz aus mehreren Teilspulen aufgebaut. Der Vorteil dieser Anordnung besteht darin, daß mit mehreren Spulen pro Shimspulensatz mehr Freiheitsgrade zur Optimierung der Shimstärke und Entkopplung vom Magneten vorhanden sind.

Eine Weiterbildung dieser Ausführungsform zeichnet sich dadurch aus, daß der radial innere Shimspulensatz aus drei axial und symmetrisch um z=0 hintereinander angeordneten Teilspulen mit Radius R aufgebaut ist, wobei die mittlere Teilspule eine axiale Länge $L_1$ mit $R \leq L_1 \leq 1.5R$ aufweist und die beiden axial äußeren Teilspulen eine zur Polarität der mittleren Teilspule entgegengesetze Polarität besitzen. Diese Anordnung ergibt die maximale Shimstärke $c_2$ eines Shimspulensatzes auf einem bestimmten Radius für eine bestimmte Zahl von Amperewindungen.

Falls bei dieser Anordnung die mittlere Teilspule aus zwei symmetrischen, gleichsinnig gewickelten Spulen besteht, kann ein zu hoher $H_4$-Gradient der mittleren Spule unterdrückt werden. Dadurch wird eine Abhängigkeit des Feldbeitrages des inneren Shimspulensatzes proportional zu $Z^4$ wirksam vermieden.

Vorteilhafterweise umfaßt der radial äußere Shimspulensatz nur Teilspulen gleicher Polarität. Die Effizienz des äußeren Shimspulensatzes zur Erzeugung von $-\Delta H_0$ würde nämlich vermindert, wenn Teilspulen unterschiedlicher Polarität verwendet würden, z.B. zur Entkopplung vom aktiv abgeschirmten Magneten.

Bevorzugt ist auch eine Ausführungsform der Erfindung, bei der der radial äußere Shimspulensatz in unmittelbarer radialer Nähe des radial äußeren Feldspulensystems des aktiv abgeschirmten Magneten angeordnet ist. Dies ermöglicht eine einfache effiziente Entkopplung des äußeren Shimspulensatzes vom aktiv abgeschirmten Magneten ohne Verwendung von Teilspulen unterschiedlicher Polarität, also ohne Abschwächung der $H_0$-Effizienz.

Vorteilhaft ist auch eine Ausführungsform, bei der die Spulen des radial inneren und/oder des radial äußeren Shimspulensatzes auf mehrere Radien verteilt sind. Dadurch werden mehr Freiheitsgrade zum Design des Shims gewonnen, insbesondere ergeben sich bessere Möglichkeiten für die Entkopplung der Shimspulensätze vom aktiv abgeschirmten Magneten.

Um einen der potentiellen Vorteile der Anordnung gemäß Anspruch 2 (nämlich daß bei externen Feldfluktuationen im Arbeitsvolumen keine Feldinhomogenität von der Form $\Delta I_2 * c_2 * z^2$ entsteht) zu realisieren, ist die Reduktion

des Dipolmoments $D_i$ des inneren Shimspulensatzes ein möglicher Weg. Dadurch wird der innere Shimspulensatz von äußeren homogenen Störquellen entkoppelt und reagiert nicht mit einer Stromänderung $\Delta I_2$, welche zu der zu vermeidenden Störung der Feldhomogenität im Arbeitsvolumen führen würde. Vorzugsweise ist das Dipolmoment $D_i \approx 0$.

Bei einer weiteren bevorzugten Ausführungsform ist die induktive Kopplung zwischen dem radial inneren und dem radial äußeren Shimspulensatz zumindest näherungsweise 0. Dadurch wird einerseits vermieden, daß sich eine allfällige Reaktion des radial äußeren Shimspulensatzes auf eine externe Störung auf den inneren übertragen kann und so zu einer Homogenitätsstörung des Feldes im Arbeitsvolumen führen würde. Andererseits erlaubt es die Entkopplung zwischen den Shimspulensätzen, daß beide individuell geladen werden können, ohne einander zu beeinflussen.

Bei einer Weiterbildung dieser Ausführungsform ist der radial äußere Shimspulensatz als $Z^0$-Shim ausgelegt. Damit erzeugt der äußere Shimspulensatz ein homogenes Feld im Arbeitsvolumen und ist entkoppelt von den anderen Spulen der Magnetanordnung. Dieser Vorteil kann aber nur mit einer entsprechenden Verdrahtung ausgenutzt werden.

Eine weitere bevorzugte Ausführungsform zeichnet sich dadurch aus, daß der radial innere Shimspulensatz elektrisch in Serie geschaltet ist mit dem radial äußeren Shimspulensatz, und daß mindestens zwei supraleitende Schalter vorgesehen sind, mit denen die beiden Shimspulensätze getrennt voneinander supraleitend kurzgeschlossen werden können. Die Serienschaltung beider Shimspulensätze ermöglicht, daß sie simultan mit einem Ladestrom geladen werden können.

In einer ersten Weiterbildung ist die Serienschaltung der beiden Shimspulensätze supraleitend.

Dann gibt es die Variante, daß einer der supraleitenden Schalter parallel zu beiden Shimspulensätzen, ein zweiter supraleitender Schalter nur parallel zu einem der beiden Shimspuiensätzen, vorzugsweise parallel zum radial inneren Shimspulensatz geschaltet ist. Dies hat den Vorteil, daß dann der radial äußere Shimspulensatz als $Z^0$-Shim genutzt werden kann.

Eine weitere Variante sieht vor, daß jeweils ein supraleitender Schalter parallel zu einem der beiden Shimspulensätze geschaltet ist.

In einer zweiten Weiterbildung ist die Serienschaltung der beiden Shimspulensätze resistiv und jeweils ein supraleitender Schalter ist parallel zu einem der beiden Shimspulensätze geschaltet.

Vorzugsweise ist ein Strombegrenzer vorgesehen, durch den der Differenzstrom zwischen dem radial inneren und dem radial äußeren Shimspulensatz fließt. Mit dem Strombegrenzer kann ein unerwünschter Differenzstrom zwischen radial innerem und äußerem Shimspulensatz abgebaut werden.

Eine vorteilhafte Weiterbildung der Erfindung zeichnet sich dadurch aus, daß die supraleitenden Schalter der beiden Shimspulensätze jeweils eine Heizeinrichtung aufweisen, die mit einer Heizeinrichtung eines anderen supraleitenden Schalters der beiden Shimspulensätze elektrisch in Serie geschaltet ist. Das simultane Laden des inneren und äußeren Shimspulensatzes bedingt, daß beide Schalter gleichzeitig geheizt (offen, also resistiv) sind. In der Anordnung nach der obigen Weiterbildung ist diese Bedingung dank der speziellen Heizerverdrahtung automatisch immer erfüllt.

Vorzugsweise sind die Heizeinrichtungen der supraleitenden Schalter der beiden Shimspulensätze separat heizbar. Daß jeder Schalter separat geheizt (offen, also resistiv) sein kann, ermöglicht das autonome Laden des inneren und/oder äußeren Shimspulensatzes (z.B. des äußeren als $Z^0$-Shims).

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1    ein Schema einer Ausführungsform der erfindungsgemäßen Magnetanordnung mit $Z^2$-Shim;

Fig. 2    ein Schema einer aktiv abgeschirmten Magnetanordnung mit $Z^2$-Shim nach dem Stand der Technik;

Fig. 3    die Radiusabhängigkeit der Feldgradienten;

Fig. 4    die Funktionen y(s);

Fig. 5    ein Schema einer dreispuligen Ausführung des radial inneren Shimspulensatzes;

Fig. 6    wie Fig. 5, aber mit zweispuliger Ausführung der mittleren Teilspule;

Fig. 7    ein elektrisches Schaltschema einer supraleitenden Serienschaltung des radial inneren und radial äußeren Shimspulensatzes mit einem ersten supraleitenden Schalter parallel zur Serienschaltung und einem zweiten supraleitenden Schalter parallel zum radial inneren Shimspulensatz;

Fig. 8    wie Fig. 7, aber mit jeweils einem supraleitenden Schalter parallel zum radial inneren und zum radial äußeren Shimspulensatz;

Fig. 9    eine resistive Serienschaltung von radial innerem und radial äußerem Shimspulensatz; und

Fig. 10    ein Schema eines zylinderförmigen Strombelags symmetrisch zum magnetischen Zentrum.

Fig. 1 zeigt ein Beispiel einer erfindungsgemäßen $Z^2$-Shimanordnung, wobei schematisch nur die rechte Hälfte einer Schnittansicht durch eine die Magnetachse z enthaltenden Ebene dargestellt ist. Die Anordnung umfaßt einen radial inneren Shimspulensatz $S_i$ bestehend aus einer Teilspule $S_1$ mit negativer Polarität und einer die Teilspule $S_1$ axial umfassenden Teilspule $S_2$ mit positiver Polarität sowie einen radial äußeren Shimspulensatz $S_a$ mit der Teilspule $S_3$ integriert in eine supraleitende Magnetanordnung bestehend aus einem Magneten $M_1$ mit mehreren Sektionen und einer aktiven Streufeldabschirmspule $M_2$.

Fig. 2 zeigt ein Schema einer supraleitenden Magnetanordnung nach dem Stand der Technik bestehend aus einem Magneten $M_1$ mit mehreren Sektionen und einer aktiven Streufeldabschirmspule $M_2$, sowie einer $Z^2$-Shimanordnung mit den Spulen $S_1'$, $S_2'$ und $S_3'$.

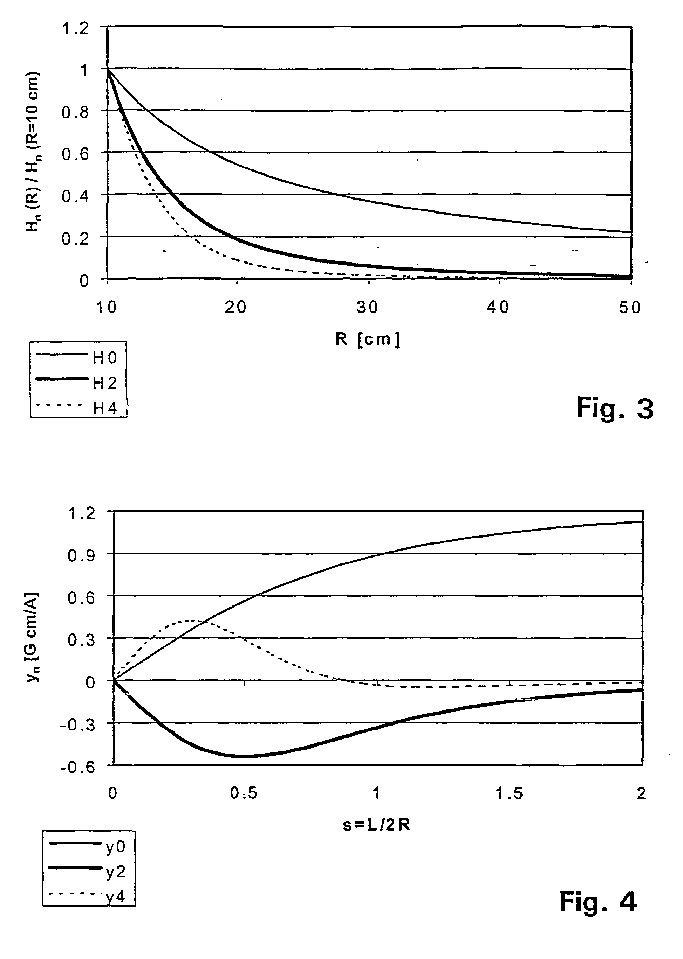

Fig. 3 stellt die Radienabhängigkeit der Feldgradienten $H_o(R)$, $H_2(R)$ und $H_4(R)$, skaliert mit $H_o(R=10\ cm)$, $H_2(R=10\ cm)$ beziehungsweise $H_4(R=10\ cm)$, für einen zylinderförmigen Strombelag j=1 [A/cm] der Länge L=10 [cm] dar.

In Fig. 4 sind $y_o$, $y_2$, $y_4$ als Funktion von $s=L/2R$ mit L: Spulenlänge, R: Spulenradius. Die $y_n$ entsprechen den Gradienten $H_n$ [G/cm$^n$] einer stromtragenden Zylindermantelfläche mit einem Radius von 1 cm und einer Stromdichte von 1 A/cm. Das Extremum von $y_2$ bei $s\approx0.5$ bedeutet, daß eine Spule von gegebenem Radius und Stromdichte bei einer Länge von $L\approx R$ am effizientesten einen $H_2$-Gradienten erzeugt.

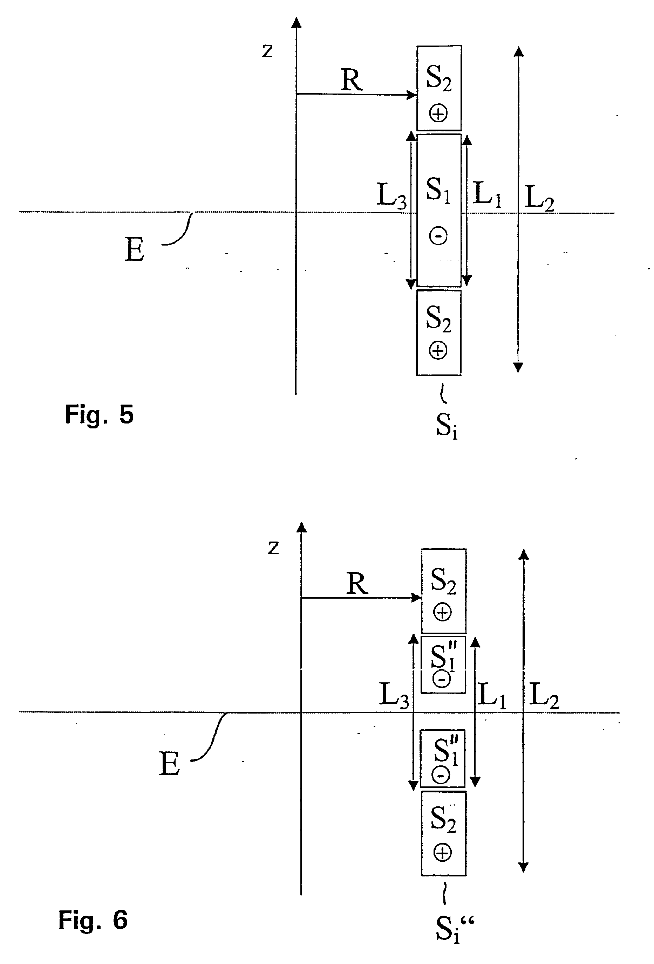

Ein der Anordnung nach Fig. 1 entsprechendes Schema einer dreispuligen Ausführung des radial inneren Shimspulensatzes $S_i$ mit den Teilspulen $S_1$ und $S_2$ bei einem Radius R ist in Fig. 5 dargestellt. Die Teilspule $S_1$ weist eine axiale Länge $L_1$ auf, während die aus zwei Spulen zusammengesetzte Teilspule $S_2$ eine axiale Länge $L_2$ besitzt, aber im Bereich der Magnetmittelebene E, wo die Teilspule $S_1$ angeordnet ist, eine Ausnehmung (= notch) der axialen Länge $L_3$ aufweist.

Fig. 6 zeigt ein Schema einer Ausführung des radial inneren Shimspulensatzes $S_i''$ eines erfindungsgemäßen $Z^2$-Shims mit zusätzlichem notch in der mittleren Teilspule $S_1''$ zur Unterdrückung einer $H_4$-"Verunreinigung" des Shimfeldes.

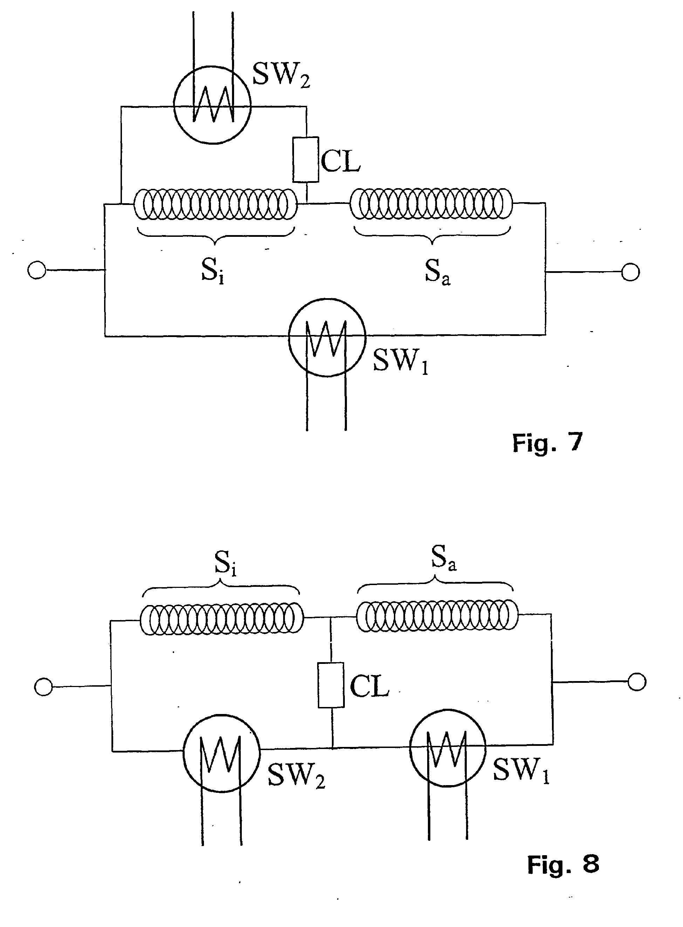

In Fig. 7 ist ein Verdrahtungsschema von radial innerem und radial äußerem Shimspulensatz $S_i$ und $S_a$ eines erfindungsgemäßen $Z^2$-Shims mit supraleitender Serienschaltung der beiden Shimspulensätze dargestellt. Ein erster supraleitender Schalter $SW_1$ überbrückt den gesamten Shim, ein zweiter supraleitender Schalter $SW_2$ nur den radial inneren Shimspulensatz $S_i$. Der Differenzstrom zwischen beiden Shimspulensätzen kann durch einen Strombegrenzer CL limitiert werden.

Bei dem Verdrahtungsschema gemäß Fig. 8 sind die beiden Shimspulensätze $S_i$ und $S_a$ ebenfalls supraleitend in Serie geschaltet. Der erste supraleitende Schalter $SW_1$ überbrückt den radial äußeren Shimspulensatz $S_a$, der zweite supraleitende Schalter $SW_2$ den radial inneren Shimspulensatz $S_i$. Der Differenzstrom zwischen beiden Shimspulensätzen kann auch hier durch einen Strombegrenzer CL limitiert werden.

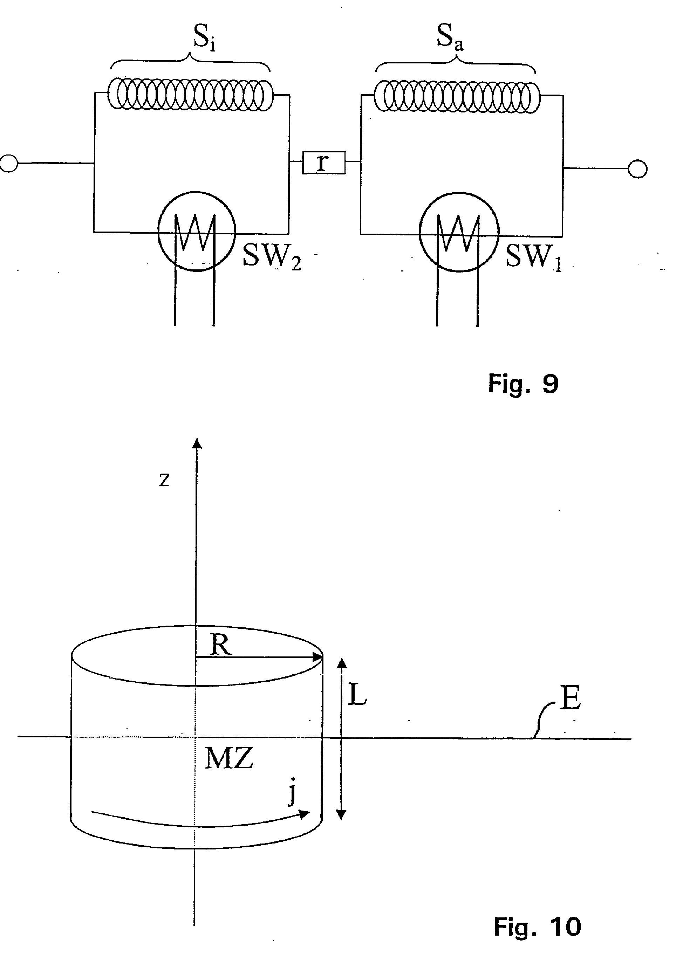

Fig. 9 hingegen zeigt ein Verdrahtungsschema von radial innerem und radial äußerem Shimspulensatz $S_i$ und $S_a$ eines erfindungsgemäßen $Z^2$-Shims mit resistiver Serienschaltung (dargestellt durch den Ersatzwiderstand r) der beiden Shimspulensätze. Der erste supraleitende Schalter $SW_1$ überbrückt den radial äußeren Shimspulensatz $S_a$, der zweite supraleitende Schalter $SW_2$ den radial inneren Shimspulensatz $S_i$.

In Fig. 10 schließlich ist das Schema eines zylinderförmigen Strombelags j mit Radius R und Länge L symmetrisch zum magnetischen Zentrum MZ dargestellt.

Die Magnetresonanzverfahren erfordern eine große Homogenität des Magnetfeldes im Probenvolumen. Um dieses Ziel zu erreichen, muß einerseits mit geeigneten Maßnahmen im Design der Magnetspule eine gute Grundhomogenität des Feldes erreicht werden, andererseits müssen produktionsbedingte Abweichungen von der vorgesehenen Grundhomogenität durch weitere Maßnahmen behoben werden.

Das Magnetfeld einer zylindersymmetrischen Magnetanordnung auf der Symmetrieachse (Richtung z) in der Nähe des magnetischen Zentrums (z=0) ist aus Symmetriegründen axial und kann geschrieben werden als

$$B(z) = H_0 + H_2 z^2 + H_4 z^4 + H_6 z^6 + H_8 z^8 + \ldots$$

wenn die Magnetspulen symmetrisch zum magnetischen Zentrum angebracht sind. Um eine möglichst gute Grundhomogenität des Feldes zu erhalten, muß man im Design des Magneten die Koeffizienten niedriger Ordnung auf null bringen. Typischerweise möchte man $H_2=H_4=0$ (eventuell $H_6$=0). Die Koeffizienten $H_n$ der Feldentwicklung werden auch Gradienten genannt.

Größere Abweichungen von der theoretischen Feldhomogenität treten vor allem in den Koeffizienten der niederen Ordnungen auf, insbesondere als nichtverschwindende Koeffizienten $H_1$ und $H_2$, aber auch als Abweichungen von der reinen Zylindersymmetrie des Feldes. Eine mögliche Maßnahme zur Korrektur dieser Feldinhomogenitäten bei supraleitenden Magnetsystemen ist beispielsweise, supraleitende Shimspulen in das Magnetsystem zu integrieren. Jede dieser Spulen hat ein spezifisches Feldprofil, d.h. erzeugt einen bestimmten Feldgradienten, und kann mit einem separaten Strom betrieben und über einen supraleitenden Schalter in sich kurzgeschlossen werden. Durch die Wahl der verschiedenen Ströme kann die Homogenität des Magnetsystems wesentlich verbessert werden. Leider benötigt jeder dieser Shims kostbaren Platz, der für die Magnetspulen verlorengeht. Für den sogenannten $Z^2$-Shim wurde mit der vorliegenden Erfindung eine besonders kompakte und effiziente Lösung gefunden, welche den Magneten nur minimal aufbläht.

Mit dem $Z^2$-Shim wird ein unerwünschter $H_2$-Gradient des Magneten eliminiert, d.h. das Feldprofil dieses Shims auf der Magnetachse ist proportional zu $z^2$. Die Effizienz oder Stärke $c_2$ des $Z^2$-Shims ist der $H_2$-Gradient, der pro Ampere erzeugt wird.

Wir betrachten einen zylinderförmigen Strombelag $j$ (in [A/cm]) der Länge $L$ symmetrisch zum magnetischen Zentrum (siehe Fig. 10). Dieser Strombelag erzeugt auf der Zylinderachse ein axiales Feld der Größe

$$B_z = H_0 + H_2 \cdot z^2 + H_4 \cdot z^4 + \ldots$$

Mit der dimensionslosen Größe

$$s = \frac{L}{2R}$$

kann man die Gradienten $H_0$, $H_2$ und $H_4$ (in [Gauss/cm$^n$]) darstellen als :

$$H_0 = jy_0(s)$$

$$H_2 = \frac{j}{R^2} y_2(s)$$

$$H_4 = \frac{j}{R^4} y_4(s)$$

mit Funktionen $y_0(s)$, $y_2(s)$ und $y_4(s)$ der Dimension [G·cm/A], die in Fig. 4 dargestellt sind. Dabei ist $R$ der Zylinderradius in [cm]. Wichtig ist die Tatsache, daß die Effizienz des Gradienten $H_n$ invers proportional zur $n$-ten Potenz des Radius $R$ ist. (Fig. 3: $H_0(R)$, $H_2(R)$ und $H_4(R)$ für eine stromtragende Zylindermantelfläche mit fester Länge $L$ und festem Strombelag $j$). Die Abhängigkeit der Gradienteneffizienz einer Spule von ihrem Radius hat zur Folge, daß ein $Z^2$-Shim auf einem kleinen Radius angebracht werden muß, wenn eine große Shim-Effizienz erreicht werden soll.

Neben der zu erreichenden Stärke $c_2$ des $Z^2$-Shims müssen beim Design von Shims für supraleitende Magnetsysteme auch noch andere Kriterien eingehalten werden, insbesondere darf der Shim keinen homogenen Feldanteil $\Delta H_0$ aufweisen und er muß vom supraleitenden Magneten induktiv entkoppelt sein. Sonst würden unerwünschte Effekte auftreten wie Feldverschiebung beim Shimen, Shimstromänderungen durch eine allfällige Magnetdrift oder hohe induzierte Ströme im Shim bei einem Quench des Magneten.

Bei einem konventionellen $Z^2$-Shim wie in Fig. 2 (als Teil eines aktiv streufeldabgeschirmten Magnetsystems gezeigt) wird versucht, all diese Kriterien durch eine Anordnung von Spulen auf demselben, für maximale Effizienz möglichst klein zu wählenden Radius zu erfüllen. Dabei geht durch die Entkopplung vom Magneten und die Unterdrückung

des $\Delta H_0$-Anteiles des Shims ein erheblicher Teil der möglichen Shimeffizienz $c_2$ verloren. Insbesondere die Unterdrükkung des $\Delta H_0$-Anteiles kann aber, wie aus Fig. 3 ersichtlich wird, auch durch einen Shimspulensatz auf einem wesentlich größeren Radius erreicht werden, als für eine effiziente Erzeugung des $H_2$-Gradienten nötig ist. Diese Möglichkeit macht sich die Erfindung zu Nutze. Durch die Auftrennung des $Z^2$-Shims in einen radial inneren Spulensatz, der auf maximale Shimstärke $c_2$ hin optimiert wird bei Vernachlässigung der dabei erzeugten $\Delta H_0$-Verunreinigung, und einen radial äußeren Shimspulensatz, mit welchem die $\Delta H_0$-Verunreinigung kompensiert wird, kann die resultierende Shimeffizienz stark gesteigert werden. Wegen der quadratischen Radiusabhängigkeit des $H_2$-Gradienten einer Spule leistet der radial äußere Shimspulensatz höchstens einen kleinen Beitrag zur Gesamt-Shimeffizienz.

Die erfindungsgemäße Spulenanordnung eines $Z^2$-Shims macht sich insbesondere beim Einsatz in aktiv streufeldabgeschirmten supraleitenden Magnetsystemen bezahlt, weil hier ein Aufblähen der Hauptspule des Magneten durch integrierte Shimspulen wegen der damit verbundenen Streufelderhöhung unbedingt vermieden werden muß und sich besonders günstige Lösungen für die erfindungsgemäße Spulenanordnung eines $Z^2$-Shims ergeben. Aus diesem Grund beschränkt sich die Erfindung auf die Beschreibung eines auf einen radial inneren und einen radial äußeren Shimspulensatz verteilten $Z^2$-Shims in einem aktiv abgeschirmten Magneten. Eine erfindungsgemäße Spulenanordnung eines $Z^2$-Shims ist in der Fig. 1 zusammen mit einem Magneten mit aktiver Streufeldkompensation gezeigt.

Anhand der obigen Diskussion des von einem zylinderförmigen Strombelag erzeugten Feldes kann eine hinsichtlich maximaler Gradientenstärke $c_2$ optimale Spulenkonfiguration für einen $Z^2$-Shim hergeleitet werden. Da die einzelnen Shimspulen normalerweise dünnwandige Solenoide sind, ist die Annäherung durch zylinderförmige Strombeläge gerechtfertigt. Für einen hypothetischen Shim aus einem einzigen bezüglich dem Magnetzentrum symmetrischen Solenoid mit Radius R ergibt sich eine Länge $L_1 \approx R$ für maximale $H_2$-Effizienz aus dem Extremum von $y_2(s)$ bei $s \approx 0.5$ (mit $s = L/2R$) (Fig. 4). Fast denselben Effekt erzielt man mit einem sehr langen Solenoid (etwa $L_2 > 4R$), wenn in der Mitte ein Bereich der Länge $L_3 \approx R$ ausgespart bleibt (sogenannter "notch"). Der erzeugte $H_2$-Gradient hat dann allerdings das entgegengesetzte Vorzeichen gegenüber der vorherigen Anordnung. Die Kombination beider Spulenanordnungen ergibt eine insgesamt dreispulige Konfiguration mit der maximalen $H_2$-Effizienz, welche für einen bestimmten Strombelag auf einem Radius $R$ überhaupt zu erzielen ist (siehe Fig. 5).

In Abhängigkeit vom Radius $R$ erzeugt eine solche Anordnung eine mehr oder weniger große $H_4$-"Verunreinigung" $\Delta H_4$ im Feld. Dem kann auf zwei Arten entgegengewirkt werden:

1. Durch Vergrößerung von $L_1$ und $L_3$ bringt man die Spulen näher zum Nulldurchgang der für $H_4$ relevanten Funktion $y_4(s)$ bei $s \approx 0.9$.

2. In der mittleren Spule bringt man einen sehr kurzen notch an mit typischerweise $s < 0.2$ (Fig. 6).

Auf beide Arten wird natürlich die $H_2$-Effizienz der Spulenkonfiguration reduziert. Insgesamt erhalten wir aber eine Konfiguration maximaler $H_2$-Effizienz unter Einhaltung der $H_4$-Reinheit, aber unter Vernachläßigung der $H_0$-Verunreinigung $\Delta H_0$. Die Kopplung mit dem Magneten kann im allgemeinen durch geeignete Wahl der Länge $L_2$ eliminiert werden. Eine solche Konfiguration ist daher optimal für den radial inneren Shimspulensatz eines erfindungsgemäßen $Z^2$-Shims (Figuren 5 und 6).

Um nun auch die Eliminierung von $\Delta H_0$ zu erreichen, bringt man mit Vorteil weitere Spulen auf einem viel größeren Radius an. Mit diesen Spulen wird die $H_2$-Effizienz des inneren Shimspulensatzes kaum beeinflußt, weil die $H_2$-Effizienz einer stromtragenden Zylinderfläche mit dem Radius quadratisch abnimmt. Eine optimale $\Delta H_0$-Kompensation mit dem radial äußeren Shimspulensatz erreicht man mit einer einzigen um die Mittelebene des Magneten zentrierten Spule. Um zur Entkopplung des radial äußeren Shimspulensatzes vom Magneten nicht zusätzliche Shimspulen anderer Polarität einführen zu müssen, kann in einem aktiv abgeschirmten Magneten die unterschiedliche Polarität von Hauptspule und Streufeldabschirmspule zur Entkopplung genutzt werden.

Das Hauptproblem der Erfindung gegenüber einem konventionellem $Z^2$-Shim ist, daß der radial äußere Shimspulensatz in seiner optimalen Ausführung ein großes Dipolmoment aufweist. Dies führt zu einer starken Kopplung mit externen Feldstörquellen, eventuell auch mit Sweep-Spulen oder Feldlock-Spulen. Dadurch können unerwünschte zeitliche Fluktuationen des Shimstroms und damit ein zeitlich variabler $H_2$-Feldgradient auftreten. Das Problem wird folgendermaßen gelöst:

1. Der radial innere und der radial äußere Shimspulensatz werden einzeln vom Magneten entkoppelt. Zur Entkopplung des äußeren Shimspulensatzes vom aktiv abgeschirmten Magneten wird mit Vorteil die unterschiedliche Polarität von Hauptspule und Streufeldabschirmung genutzt.

2. Der radial innere und der radial äußere Shimspulensatz werden separat supraleitend kurzgeschlossen. Durch die separate Entkopplung vom Magneten bleiben unerwünschte Effekte wie Shimstromänderungen durch eine allfällige Magnetdrift oder hohe induzierte Ströme im Shim bei einem Quench des Magneten auch mit dem separaten supraleitenden Kurzschluß beider Shimspulensätze ausgeschlossen.

3. Um eine gute Stabilität der $H_2$-Homogenität bei externen Fetdftuktuationen / Aktivierung des Feldlocks / Betätigen von Feldsweep-Spulen zu erhalten, genügt es nun, den inneren Shimspulensatz von der Störquelle / der Lockspule / den Sweep-Spulen zu entkoppeln, weil der äußere nur wenig $H_2$ erzeugt. Die Entkopplung des inneren Shimspulensatzes von einer externen Störquelle wird im Falle einer homogenen Feldstörung mit einem verschwindenden Dipolmoment des inneren Shimspulensatzes erreicht.

4. Eine zusätzlich verbesserte zeitliche Stabilität der $H_2$-Homogenität wird erreicht, indem der radial innere und äußere Shimspulensatz voneinander entkoppelt werden, weil dann über einen allfällig im radial äußeren Shimspulensatz induzierten Strom kein Strom im radial inneren Shimspulensatz induziert werden kann.

Wie der radial äußere Shimspulensatz bei externen Feldfluktuationen / Aktivierung des Feldlocks / Betätigen von Feldsweep-Spulen reagiert, beeinflußt in erster Linie das zeitliche Verhalten des <u>homogenen</u> Feldanteils $H_0(t)$ im Probenvolumen. Optimal ist eine Designlösung für den radial äußeren Shimspulensatz, bei welcher die Wechselwirkung mit der Feldlockspule und allfällig vorhandenen Feldsweep-Spulen verschwindet, während bei einer externen Störung als Reaktion eine Stromänderung im radial äußeren Shimspulensatz, welche ein dem Störfeld entgegenwirkendes Feld aufbaut, gewünscht wird. Falls die Feldlockspule und allfällig vorhandene Feldsweep-Spulen im Bereich des Magnetzentrums angebracht sind, wird sich das gewünschte Verhalten des radial äußeren Shimspulensatzes gegenüber diesen Spulen ohne weitere Designmaßnahmen allein durch den großen Radius der Shimspulen ergeben. Was das Verhalten gegenüber externen Feldstörquellen betrifft, so ergibt sich insbesondere bei aktiv abgeschirmten Magneten durch die Grundkonfiguration der erfindungsgemäßen $Z^2$-Shimanordnung mit separatem supraleitendem Kurzschluß von radial innerem und äußerem Shimspulensatz ohne weitere Designmaßnahmen im allgemeinen eine starke Verbesserung der Anfälligkeit des Magnetsystems auf den homogenen Feldanteil externer Feldfluktuationen.

Der separate supraleitende Kurzschluß von radial innerem und äußerem Shimspulensatz hat zwei weitere vorteilhafte Konsequenzen:

- Die Verbindung von radial innerem und äußerem Shimspulensatz kann außer supraleitend nun auch resistiv ausgeführt werden, mit entsprechenden Vereinfachungen für die Produktion des Shims.

- Die beiden Shimspulensätze können mit unterschiedlichen Strömen betrieben werden. Insbesondere ergibt sich die Möglichkeit, den radial äußeren Shimspulensatz als $Z^0$-Shim zu betreiben, da er alle Anforderungen an einen solchen Shim erfüllt. Er ist entkoppelt von allen supraleitend kurzgeschlossenen Strompfaden im Magnetsystem und erzeugt ein homogenes Feld $H_0$.

Mögliche Realisierungen des separaten supraleitenden Kurzschlusses von radial innerem und äußerem Shimspulensatz sind in den Figuren 7-9 schematisch dargestellt. Die resistive Verbindung von radial innerem und äußerem Shimspulensatz ist durch einen Ersatzwiderstand r symbolisiert. Im Falle der supraleitenden Verbindung von radial innerem und äußerem Shimspulensatz kann der Differenzstrom zwischen radial innerem und äußerem Shimspulensatz durch einen Strombegrenzer CL limitiert werden.

Wenn der radial innere und äußere Shimspulensatz separat supraleitend kurzgeschlossen werden, muß jeder der beiden supraleitend geschlossenen Strompfade einen eigenen supraleitenden Schalter aufweisen, welcher zum Laden des zugehörigen Strompfades geöffnet wird. Beim Laden des Gesamtshims müssen beide Schalter simultan offen sein. Dies wird automatisch erfüllt, wenn die Schalterheizer in Serie geschaltet sind. In gewissen Situationen, wie z.B. Verwendung des radial äußeren Shimspulensatzes als $Z^0$-Shim, ist es notwendig, daß die einzelnen Schalter zusätzlich auch individuell geöffnet werden können.

**Patentansprüche**

1. Supraleitende Magnetanordnung für magnetische Resonanz-Spektrometer, wobei die Magnetanordnung einen aktiv abgeschirmten supraleitenden Magneten zur Erzeugung eines homogenen Magnetfelds $H_0$ entlang einer z-Achse in einem um z=0 angeordneten Arbeitsvolumen mit einem radial inneren Spulensystem ($M_1$) und einem radial äußeren Spulensystem ($M_2$) umfaßt, wobei die beiden Spulensysteme ($M_1$, $M_2$) näherungsweise den gleichen Strom tragen und näherungsweise entgegengesetzt gleich große Dipolmomente aufweisen, und wobei eine Shimanordnung vorgesehen ist, welche ein supraleitendes Shimspulensystem zur Korrektur von Magnetfeld-Inhomogenitäten im Arbeitsvolumen umfaßt, deren z-Komponente proportional zu $z^2$ variiert,
**dadurch gekennzeichnet,**

**daß** das Shimspulensystem einen radial inneren Shimspulensatz ($S_i$; $S_i''$) umfaßt, der von dem supraleitenden Magneten ($M_1$, $M_2$) der Magnetanordnung induktiv weitgehend entkoppelt ist und im Arbeitsvolumen überwiegend ein Magnetfeld erzeugt, dessen z-Komponente wie $\Delta H_0 + c_2 \cdot z^2$ mit $c_2$ = const. variiert, sowie einen radial äußeren Shimspulensatz ($S_a$), der ebenfalls von dem Supraleitenden Magneten ($M_1$, $M_2$) der Magnetanordnung induktiv weitgehend entkoppelt ist und im Arbeitsvolumen überwiegend ein homogenes Magnetfeld $-\Delta H_0$ erzeugt.

2. Magnetanordnung nach Anspruch 1, **dadurch gekennzeichnet, daß** sowohl der radial innere Shimspulensatz ($S_i$; $S_i''$) als auch der radial äußere Shimspulensatz ($S_a$) jeweils für sich supraleitend kurzgeschlossen werden kann

3. Magnetanordnung nach einem der vorhergehenden Ansprüche, **dadurch gekennzeichnet, daß** die Magnetanordnung Teil einer Apparatur zur hochauflösenden Magnetresonanz-Spektroskopie ist.

4. Magnetanordnung nach Anspruch 3 **dadurch gekennzeichnet, daß** die Magnetresonanz-Apparatur eine Einrichtung zum Feldlock des im Arbeitsvolumen erzeugten Magnetfelds aufweist, wobei der radial innere Shimspulensatz ($S_i$; $S_i''$) und der radial äußere Shimspulensatz ($S_n$) weitgehend von den Spulen der Einrichtung zum Feldlock entkoppelt sind.

5. Magnetanordnung nach Anspruch 3 oder 4, **dadurch gekennzeichnet, daß** die Magnetresonanz-Apparatur Sweep-Spulen aufweist, wobei der radial innere Shimspulensatz ($S_i$; $S_i''$) und der radial äußere Shimspulensatz ($S_a$) weitgehend von den Sweep-Spulen entkoppelt sind.

6. Magnetanordnung nach einem der vorhergehenden Ansprüche, **dadurch gekennzeichnet, daß** der radial innere und/oder der radial äußere Shimspulensatz ($S_i$; $S_i''$ bzw. $S_a$) aus mehreren Teilspulen ($S_1$, $S_2$, $S_3$; $S_1''$) aufgebaut ist.

7. Magnetanordnung nach Anspruch 6, **dadurch gekennzeichnet, daß** der radial innere Shimspulensatz ($S_i$; $S_i''$) aus drei axial und symmetrisch um z=0 hintereinander angeordneten Teilspulen ($S_1$, $S_2$; $S_1''$) mit Radius R aufgebaut ist, wobei die mittlere Teilspule ($S_1$, $S_1''$) eine axiale Länge $L_1$ mit $R \leq L_1 \leq 1.5R$ aufweist und die beiden axial äußeren Teilspulen ($S_2$) eine zur Polarität der mittleren Teilspule ($S_1$; $S_1''$) entgegengesetzte Polarität besitzen.

8. Magnetanordnung nach Anspruch 7, **dadurch gekennzeichnet, daß** die mittlere Teilspule ($S_1''$) aus zwei symmetrischen, gleichsinnig gewickelten Spulen besteht.

9. Magnetanordnung nach einem der Ansprüche 6 bis 8, **dadurch gekennzeichnet, daß** der radial äußere Shimspulensatz ($S_a$) nur Teilspulen ($S_3$) gleicher Polarität umfaßt.

10. Magnetanordnung nach einem der vorhergehenden Ansprüche, **dadurch gekennzeichnet, daß** der radial äußere Shimspulensatz ($S_a$) in unmittelbarer radialer Nähe des radial äußeren Feldspulensystems ($M_2$) des aktiv abgeschirmten Magneten angeordnet ist.

11. Magnetanordnung nach einem der vorhergehenden Ansprüche, **dadurch gekennzeichnet, daß** die Spulen des radial inneren und/oder des radial äußeren Shimspulensatzes ($S_i$, $S_a$; $S_i''$) auf mehrere Radien verteilt sind.

12. Magnetanordnung nach einem der vorhergehenden Ansprüche, **dadurch gekennzeichnet, daß** der radial innere Shimspulensatz ($S_i$; $S_i''$) ein kleineres Dipolmoment $D_i$ als der radial äußere Shimspulensatz ($S_a$) aufweist, vorzugsweise $D_i \approx 0$.

13. Magnetanordnung nach einem der vorhergehenden Ansprüche, **dadurch gekennzeichnet, daß** die induktive Kopplung zwischen dem radial inneren ($S_i$; $S_i''$) und dem radial äußeren ($S_a$) Shimspulensatz zumindest näherungsweise 0 ist.

14. Magnetanordnung nach Anspruch 13, **dadurch gekennzeichnet, daß** der radial äußere Shimspulensatz ($S_a$) als $Z^0$-Shim ausgelegt ist.

15. Magnetanordnung nach einem der vorhergehenden Ansprüche, **dadurch gekennzeichnet, daß** der radial innere Shimspulensatz ($S_i$; $S_i''$) elektrisch in Serie geschaltet ist mit dem radial äußeren Shimspulensatz ($S_a$), und daß mindestens zwei supraleitende Schalter ($SW_1$, $SW_2$) vorgesehen sind, mit denen die beiden Shimspulensätze getrennt voneinander supraleitend kurzgeschlossen werden können.

16. Magnetanordnung nach Anspruch 15, **dadurch gekennzeichnet, daß** die Serienschaltung von radial innerem und radial äußerem Shimspulensatz supraleitend ist, und daß einer der supraleitenden Schalter ($SW_1$) parallel zu beiden Shimspulensätzen ($S_i$, $S_a$), ein zweiter supraleitender Schalter ($SW_2$) nur parallel zu einem der beiden Shimspulensätze, vorzugsweise parallel zum radial inneren Shimspulensatz ($S_i$) geschaltet ist.

17. Magnetanordnung nach Anspruch 15, **dadurch gekennzeichnet, daß** die Serienschaltung von radial innerem und radial äußerem Shimspulensatz supraleitend ist, und daß jeweils ein supraleitender Schalter ($SW_1$, $SW_2$) parallel zu einem der beiden Shimspulensätze ($S_i$, $S_a$) geschaltet ist.

18. Magnetanordnung nach Anspruch 15, **dadurch gekennzeichnet, daß** die beiden Shimspulensätze ($S_i$, $S_a$) resistiv in Serie geschaltet sind, und daß jeweils ein supraleitender Schalter ($SW_1$, $SW_2$) parallel zu einem der beiden Shimspulensätze ($S_i$, $S_a$) geschaltet ist.

19. Magnetanordnung nach einem der Ansprüche 16 oder 17, **dadurch gekennzeichnet, daß** ein Strombegrenzer (CL) vorgesehen ist, durch den der Differenzstrom zwischen dem radial inneren und dem radial äußeren Shimspulensatz ($S_i$, $S_a$) fließt.

20. Magnetanordnung nach einem der Ansprüche 15 bis 19, **dadurch gekennzeichnet, daß** die supraleitenden Schalter ($SW_1$, $SW_2$) der beiden Shimspulensätze ($S_i$, $S_a$) jeweils eine Heizeinrichtung aufweisen, die mit einer Heizeinrichtung eines anderen supraleitenden Schalters ($SW_2$, $SW_1$) der beiden Shimspulensätze ($S_i$, $S_a$) elektrisch in Serie geschaltet ist.

21. Magnetanordnung nach Anspruch 20, **dadurch gekennzeichnet, daß** die Heizeinrichtungen der supraleitenden Schalter ($SW_1$, $SW_2$) der beiden Shimspulensätze ($S_i$, $S_a$) separat heizbar sind.


**Claims**

1. Superconducting magnet system for magnetic resonance spectrometers, wherein the magnet system comprises an actively shielded superconducting magnet for generating a homogeneous magnetic field $H_0$ along a z-axis in a working volume disposed about z=0 comprising a radially inner coil system ($M_1$) and a radially outer coil system ($M_2$), wherein the two coil systems ($M_1$, $M_2$) carry approximately identical currents and have approximately identical opposite dipole moments, and wherein a shim system is provided comprising a superconducting shim coil system for correcting magnetic field inhomogeneities in the working volume, the z component of which varies proportionally to $Z^2$,
   **characterized in that**
   the shim coil system comprises a radially inner shim coil set ($S_i$; $S_i''$) which is substantially inductively decoupled from the superconducting magnet ($M_1$, $M_2$) of the magnet system and mainly generates in the working volume a magnetic field whose z component varies like $\Delta H_0 + c_2.z^2$ with c2=const., and a radially outer shim coil set ($S_a$), which is also substantially inductively decoupled from the superconducting magnet ($M_1$, $M_2$) of the magnet system and mainly generates a homogeneous magnetic field $-\Delta H0$ in the working volume.

2. Magnet system according to claim 1, **characterized in that** the radially inner shim coil set ($S_i$; $S_i''$) and also the radially outer shim coil set ($S_a$) can each be separately superconductingly short-circuited.

3. Magnet system according to any one of the preceding claims, **characterized in that** the magnet system is part of an apparatus for high-resolution magnetic resonance spectroscopy.

4. Magnet system according to claim 3, **characterized in that** the magnetic resonance apparatus comprises a means for field-locking the magnetic field generated in the working volume, wherein the radially inner shim coil set ($S_i$; $S_i''$) and the radially outer shim coil set ($S_a$) are largely decoupled from the coils of the field-locking means.

5. Magnet system according to claim 3 or 4, **characterized in that** the magnetic resonance apparatus comprises sweep coils, wherein the radially inner shim coil set ($S_i$, $S_i''$) and the radially outer shim coil set ($S_a$) are largely decoupled from the sweep coils.

6. Magnet system according to any one of the preceding claims, **characterized in that** the radially inner and/or the radially outer shim coil set ($S_i$, $S_i''$ and $S_a$, respectively) are formed from several partial coils ($S_1$, $S_2$, $S_3$; $S_1''$).

7. Magnet system according to claim 6, **characterized in that** the radially inner shim coil set ($S_i$, $S_i''$) is formed of three partial coils ($S_1$, $S_2$; $S_1''$) disposed, behind one another, axially and symmetrically about z=0 with a radius R, wherein the central partial coil ($S_1$, $S_1''$) has an axial length $L_1$ of $R \leq L_1 \leq 1.5R$ and the two axially outer partial coils ($S_2$) have a polarity opposite to the polarity of the central partial coil ($S_1$; $S_2''$).

8. Magnet system according to claim 7, **characterized in that** the central partial coil ($S_1'$) consists of two symmetrical coils wound in the same direction.

9. Magnet system according to any one of the claims 6 through 8, **characterized in that** the radially outer shim coil set ($S_a$) has only partial coils ($S_3$) of the same polarity.

10. Magnet system according to any one of the preceding claims, **characterized in that** the radially outer shim coil set ($S_a$) is disposed radially in the direct vicinity of the radially outer field coil system ($M_2$) of the actively shielded magnet.

11. Magnet system according to any one of the preceding claims, **characterized in that** the coils of the radially inner and/or the radially outer shim coil set ($S_i$, $S_a$; $S_i''$) are distributed on several radii.

12. Magnet system according to any one of the preceding claims, **characterized in that** the radially inner shim coil set ($S_i$; $S_i''$) has a smaller dipole moment $D_i$ than the radially outer shim coil set ($S_a$), preferably $D_i \approx 0$.

13. Magnet system according to any one of the preceding claims, **characterized in that** the inductive coupling between the radially inner ($S_i$; $S_i''$) and the radially outer ($S_a$) shim coil set is at least approximately 0.

14. Magnet system according to claim 13, **characterized in that** the radially outer shim coil set ($S_a$) is designed as $Z^0$ shim.

15. Magnet system according to any one of the preceding claims, **characterized in that** the radially inner shim coil set ($S_i$; $S_i''$) is electrically connected in series with the radially outer shim coil set ($S_a$) and that at least two superconducting switches ($SW_1$, $SW_2$) are provided with which the two shim coil sets can be superconductingly short-circuited independently of one another.

16. Magnet system according to claim 15, **characterized in that** the series connection between the radially inner and radially outer shim coil sets is superconducting and that one of the superconducting switches ($SW_1$) is connected in parallel with the two shim coil sets ($S_i$, $S_a$), a second superconducting switch ($SW_2$) is connected only in parallel with one of the two shim coil sets, preferably in parallel with the radially inner shim coil set ($S_i$).

17. Magnet system according to claim 15, **characterized in that** the series connection between the radially inner and radially outer shim coil sets is superconducting and that one superconducting switch ($SW_1$, $SW_2$) is connected in parallel with one of the two shim coil sets ($S_i$, $S_a$).

18. Magnet system according to claim 15, **characterized in that** the two shim coil sets ($S_i$, $S_a$) are resistively connected in series and that one superconducting switch ($SW_1$, $SW_2$) is connected in parallel with one of the two shim coil sets ($S_i$, $S_a$).

19. Magnet system according to any one of the claims 16 or 17, **characterized in that** a current limiter (CL) is provided to reduce the differential current between the radially inner and the radially outer shim coil set ($S_i$, $S_a$).

20. Magnet system according to any one of the claims 15 through 19, **characterized in that** the superconducting switches ($SW_1$, $SW_2$) of the two shim coil sets ($S_i$, $S_a$) each comprise a heating means which is electrically connected in series with the heating means of another superconducting switch ($SW_2$, $SW_1$) of the two shim coil sets ($S_i$, $S_a$).

21. Magnet system according to claim 20, **characterized in that** the heating means of the superconducting switches ($SW_1$, $SW_2$) of the two shim coil sets ($S_i$, $S_a$) can be heated separately.

**Revendications**

1. Dispositif magnétique supraconducteur pour spectromètres à résonance magnétique, lequel dispositif magnétique comprend un aimant supraconducteur à blindage actif pour générer un champ magnétique homogène $H_0$ le long d'un axe z dans un volume de travail situé autour de z = 0 avec un système de bobines radialement intérieur ($M_1$) et un système de bobines radialement extérieur ($M_2$), les deux systèmes de bobines ($M_1$, $M_2$) portant approximativement le même courant et présentant des moments dipolaires approximativement opposés et égaux, et dans lequel il est prévu un dispositif de shim qui comprend un système de bobines de shim supraconductrices pour corriger les inhomogénéités de champ magnétique dans le volume de travail, dont la composante z varie proportionnellement à $z^2$,

**caractérisé par le fait**

**que** le système de bobines de shim comprend un jeu de bobines de shim radialement intérieur ($S_i'$ ; $S_i''$) qui est en grande partie découplé inductivement de l'aimant supraconducteur ($M_1$, $M_2$) du dispositif magnétique et génère dans le volume de travail essentiellement un champ magnétique dont la composante z varie comme $\Delta H_0 + c_2 \cdot z^2$ avec $c_2$ = const., ainsi qu'un jeu de bobines de shim radialement extérieur ($S_a$) qui est également en grande partie découplé inductivement de l'aimant supraconducteur ($M_1$, $M_2$) du dispositif magnétique et génère dans le volume de travail essentiellement un champ magnétique homogène $-\Delta H_0$.

2. Dispositif magnétique selon la revendication 1, **caractérisé par le fait qu'**aussi bien le jeu de bobines de shim radialement intérieur ($S_i$ ; $S_i''$) que le jeu de bobines de shim radialement extérieur ($S_a$) peuvent être court-circuités de manière supraconductrice.

3. Dispositif magnétique selon l'une des revendications précédentes, **caractérisé par le fait que** le dispositif magnétique fait partie d'un appareil pour la spectroscopie par résonance magnétique à haute résolution.

4. Dispositif magnétique selon la revendication 3, **caractérisé par le fait que** l'appareil de résonance magnétique présente un dispositif de stabilisation du champ magnétique généré dans le volume de travail, le jeu de bobines de shim radialement intérieur ($S_i$; $S_i''$) et le jeu de bobines de shim radialement extérieur ($S_a$) étant en grande partie découplés des bobines du dispositif de stabilisation de champ.

5. Dispositif magnétique selon la revendication 3 ou 4, **caractérisé par le fait que** l'appareil de résonance magnétique présente des bobines de balayage, le jeu de bobines de shim radialement intérieur ($S_i$ ; $S_i''$) et le jeu de bobines de shim radialement extérieur ($S_a$) étant en grande partie découplés des bobines de balayage.

6. Dispositif magnétique selon l'une des revendications précédentes, **caractérisé par le fait que** le jeu de bobines de shim radialement intérieur et/ou radialement extérieur ($S_i$; $S_i''$ et/ou $S_a$) est constitué de plusieurs bobines partielles ($S_1$, $S_2$, $S_3$ ; $S_1''$).

7. Dispositif magnétique selon la revendication 6, **caractérisé par le fait que** le jeu de bobines de shim radialement intérieur ($S_i$; $S_i''$) est constitué de trois bobines partielles ($S_1$, $S_2$ ; $S_i''$) de rayon R disposées l'une derrière l'autre axialement et symétriquement autour de z = 0, la bobine partielle centrale ($S_1$, $S_i''$) présentant une longueur axiale $L_1$ avec $R \le L_1 \le 1,5\ R$ et les deux bobines partielles axialement extérieures ($S_2$) possédant une polarité opposée à celle de la bobine partielle centrale ($S_1$, $S_1''$).

8. Dispositif magnétique selon la revendication 7, **caractérisé par le fait que** la bobine partielle centrale ($S_1''$) est composée de deux bobines symétriques enroulées dans le même sens.

9. Dispositif magnétique selon l'une des revendications 6 à 8, **caractérisé par le fait que** le jeu de bobines de shim radialement extérieur ($S_a$) ne comprend que des bobines partielles ($S_3$) de même polarité.

10. Dispositif magnétique selon l'une des revendications précédentes, **caractérisé par le fait que** le jeu de bobines de shim radialement extérieur ($S_a$) est disposé à proximité radiale immédiate du système de bobines radialement extérieur ($M_2$) de l'aimant à blindage actif.

11. Dispositif magnétique selon l'une des revendications précédentes, **caractérisé par le fait que** les bobines du jeu de bobines de shim radialement intérieur et/ou radialement extérieur ($S_i$, $S_a$ ; $S_i''$) sont réparties sur plusieurs rayons.

12. Dispositif magnétique selon l'une des revendications précédentes, **caractérisé par le fait que** le jeu de bobines de shim radialement intérieur ($S_i$; $S_i''$) présente un plus petit moment dipolaire $D_i$ que le jeu de bobines de shim radialement extérieur ($S_a$), de préférence $D_i \approx 0$.

**13.** Dispositif magnétique selon l'une des revendications précédentes, **caractérisé par le fait que** le couplage inductif entre les jeux de bobines de shim radialement intérieur ($S_i$; $S_i''$) et radialement extérieur ($S_a$) est, au moins approximativement, nul.

**14.** Dispositif magnétique selon la revendication 13, **caractérisé par le fait que** le jeu de bobines de shim radialement extérieur ($S_a$) est conçu comme un shim $Z^0$.

**15.** Dispositif magnétique selon l'une des revendications précédentes, **caractérisé par le fait que** le jeu de bobines de shim radialement intérieur ($S_i$; $S_i''$) est couplé électriquement en série avec le jeu de bobines de shim radialement extérieur ($S_a$) et qu'il est prévu au moins deux commutateurs supraconducteurs ($SW_1$, $SW_2$) avec lesquels il est possible de court-circuiter de manière supraconductrice séparément les deux jeux de bobines de shim.

**16.** Dispositif magnétique selon la revendication 15, **caractérisé par le fait que** le couplage en série des jeux de bobines de shim radialement intérieur et radialement extérieur est supraconducteur et qu'un des commutateurs supraconducteurs ($SW_1$) est couplé en parallèle avec les deux jeux de bobines de shim ($S_i$, $S_a$) et qu'un deuxième commutateur supraconducteur ($SW_2$) est couplé en parallèle seulement avec un des deux jeux de bobines de shim, de préférence avec le jeu de bobines de shim radialement intérieur ($S_i$).

**17.** Dispositif magnétique selon la revendication 15, **caractérisé par le fait que** le couplage en série des jeux de bobines de shim radialement intérieur et radialement extérieur est supraconducteur et que chacun des commutateurs supraconducteurs ($SW_1$, $SW_2$) est couplé en parallèle avec un des deux jeux de bobines de shim ($S_i$, $S_a$).

**18.** Dispositif magnétique selon la revendication 15, **caractérisé par le fait que** les deux jeux de bobines de shim ($S_i$, $S_a$) sont couplés en série de manière résistive et que chacun des commutateurs supraconducteurs ($SW_1$, $SW_2$) est couplé en parallèle avec un des deux jeux de bobines de shim ($S_i$, $S_a$).

**19.** Dispositif magnétique selon l'une des revendications 16 ou 17, **caractérisé par le fait qu'**il est prévu un limiteur de courant (CL) à travers lequel circule le courant différentiel entre les jeux de bobines de shim radialement intérieur et radialement extérieur ($S_i$, $S_a$).

**20.** Dispositif magnétique selon l'une des revendications 15 à 19, **caractérisé par le fait que** les commutateurs supraconducteurs ($SW_1$, $SW_2$) des deux jeux de bobines de shim ($S_i$, $S_a$) présentent chacun un dispositif de chauffage qui est couplé électriquement en série avec un dispositif de chauffage d'un autre commutateur supraconducteur ($SW_2$, $SW_1$) des deux jeux de bobines de shim ($S_i$, $S_a$).

**21.** Dispositif magnétique selon la revendication 20, **caractérisé par le fait que** les dispositifs de chauffage des commutateurs supraconducteurs ($SW_1$, $SW_2$) des deux jeux de bobines de shim ($S_i$, $S_a$) sont chauffables séparément.

**Fig. 1**

**Fig. 2**

Fig. 3

Fig. 4

**Fig. 5**

**Fig. 6**

**Fig. 7**

**Fig. 8**

Fig. 9

Fig. 10